# EUROPEAN PATENT SPECIFICATION

(11) **EP 1 538 485 B1**
(45) Date of publication and mention of the grant of the patent: **30.07.2008**
(21) Application number: 04257363.4
(22) Date of filing: 26.11.2004
(51) Int. Cl.: G03F 9/00

(54) **Method of Preparing a Substrate, Method of Measuring, Device Manufacturing Method, Lithographic Apparatus, Computer Program and Substrate**
Verfahren zur Vorbereitung eines Substrats, Messverfahren, Verfahren zur Herstellung einer Vorrichtung, Lithographischer Apparat, Computerprogramm und Substrat
Procédé de préparation d'un substrat, méthode de mesure, méthode de fabrication d'un dispositif, appareil lithographique, programme d'ordinateur et substrat

(30) Priority: 01.12.2003 US 724403
(43) Date of publication of application: 08.06.2005
(73) Proprietor: ASML Netherlands B.V., 5504 DR Veldhoven (NL)
(72) Inventor: Ten Berge, Peter, 5614 AM Eindhoven (NL); Keijsers, Gerardus Johannes Joseph, 5913 DM Venlo (NL)
(74) Representative: Leeming, John Gerard

(56) References cited:
- US-A1- 2001 020 750
- US-A1- 2002 072 193
- US-B1- 6 177 285
- LAI J M ET AL: "PRECISION ALIGNMENT OF MASK ETCHING WITH RESPECT TO CRYSTAL ORIENTATION" JOURNAL OF MICROMECHANICS & MICROENGINEERING, NEW YORK, NY, US, vol. 8, no. 4, December 1998 (1998-12), pages 327-329, XP001028556 ISSN: 0960-1317

## Description

The present invention relates to a method of preparing a substrate, a method of measuring, a device manufacturing method, a lithographic apparatus, a computer program for controlling the lithographic apparatus and a substrate.

A lithographic apparatus is a machine that applies a desired pattern onto a target portion of a substrate. Lithographic apparatus can be used, for example, in the manufacture of integrated circuits (ICs). In that circumstance, a patterning means, such as a mask, may be used to generate a circuit pattern corresponding to an individual layer of the IC, and this pattern can be imaged onto a target portion (e.g. comprising part of, one or several dies) on a substrate (e.g. a silicon wafer) that has a layer of radiation-sensitive material (resist). In general, a single substrate will contain a network of adjacent target portions that are successively exposed. Known lithographic apparatus include so-called steppers, in which each target portion is irradiated by exposing an entire pattern onto the target portion in one go, and so-called scanners, in which each target portion is irradiated by scanning the pattern through the projection beam in a given direction (the "scanning"-direction) while synchronously scanning the substrate parallel or anti-parallel to this direction.

Some devices that are made by lithographic techniques, for example devices including optical waveguides, need to be correctly aligned to the crystal structure of the substrate on which they are built. In conventional silicon wafers, the flat is formed by cleaving the silicon crystal before it is sawn into wafers and hence gives an indication of the crystal axis. In wafers with a notch rather than a flat, the position of the notch indicates the orientation of the crystal axis. However, both flats and notches only indicate the {110} crystal axis to within ±1° which is insufficient for many applications. GaAs {011} and InP {011} wafers are typically specified with a tolerance of ±0.5° but again more accurate alignment is often necessary.

Techniques for determining the crystal orientation of Si and InP substrates by anisotropic etching of patterns are disclosed in: G. Ensell, Sens. Actuators A, 53, 345 (1996); M. Vangbo, Y. Backlund, J. Micromech. Microeng., 6, 279 (1996); J.M. Lai, W.H. Chieng, Y-C. Huang, J. Micromech. Microeng., 8, 327 (1998) and M. Vangbo, A. Richard, M. Karlsson, K. Hjort, Electrochemical and Solid-State Letters, 2 (8) 407 (1999). However none of these documents describes a methodology that can be easily automated and the results fed directly into a production process.

It is an object of the present invention to provide an improved and preferably more accurate or convenient way of measuring the orientation of the crystal axis of a substrate.

According to an aspect of the invention, there is provided a method of preparing a substrate comprising:
providing on a surface of said substrate a plurality of alignment markers at respective predetermined positions, different ones of said alignment markers having different orientations relative to a crystal axis of said substrate and the form of said alignment markers being such that their apparent position is dependent on their orientation relative to said crystal axis,
characterized in that the alignment markers each comprise a structure, the structure comprising a solid area, a clear area and a striped area.

By printing on the substrate a plurality of markers of different orientations and whose apparent positions depend on their orientations relative to the crystal axis, a rapid and accurate determination of the orientation of the crystal axis can be carried out using known and accurate alignment systems. In particular, the alignment system built into a lithographic apparatus may be used. The orientations of the alignment markers preferably span the expected range of variation of the orientation of the crystal axis and a little way either side, for example between 0.5° to 2° either side of a nominal orientation of said crystal axis. The intervals between the orientations should be sufficient to give enough data points for interpolation and error averaging to give a measurement of the desired accuracy for example, the orientations of said alignment markers may differ from each other by amounts in the range of from (5x10⁻⁶)° to 4°. The smallest increment of angle may be determined by the minimum rotational step of the substrate table of a lithographic apparatus used to print and/or measure the markers.

According to a preferred embodiment of the invention, the dependence on orientation of the markers' positions is provided by etching said alignment markers into said substrate using an anisotropic etching process.

According to a further aspect of the invention, there is provided a method of determining the orientation of the crystal structure of a substrate, the substrate having provided thereon a plurality of alignment markers at respective predetermined positions, different ones of said alignment markers having different orientations relative to a crystal axis of said substrate and each comprising a structure, the structure comprising a solid area, a clear area and a striped area; the method comprising:
measuring the positions of said plurality of alignment markers;
determining the deviations of the measured positions of said alignment markers from said predetermined positions;
determining the orientation of said crystal axis relative to said plurality of alignment markers from said deviations.

This method may be used with the substrates of the first aspect of the invention to obtain the desired measurement of the orientation of the crystal axis.

The measurement of the orientation of the crystal axis may be carried out at a different time, and possibly also place, in which case it is desirable to mark on said substrate and/or other substrates cut from the same crystal, information indicative of the determined orientation, or to make an entry in a database representing said determined orientation.

Yet a further aspect of the present invention provides a device manufacturing method comprising the steps of:
- providing a substrate;
- providing a projection beam of radiation using an illumination system;
- using patterning means to impart the projection beam with a pattern in its cross-section; and
- projecting the patterned beam of radiation onto a target portion of the substrate,
characterized in that during said projection, the orientation of said substrate relative to the projected pattern is determined at least in part by reference to information indicative of the orientation of a crystal axis that has been determined by the method of claim 5, 6 or 7.

In this way, structures whose function is dependent upon or improved by correct orientation with respect to the crystal axis of the substrate, can be appropriately aligned to the crystal axis. In this method, the markers from which the orientation of the crystal axis is derived may be provided on the opposite side of the substrate than the devices that are to be manufactured. Also, the information indicative of the orientation of a crystal axis can be derived from measurements of a different substrate cut from the same single crystal.

The alignment marker may take the form of any standard markers, for example gratings, groups of gratings, chevrons, boxes. Sensitivity to orientation can be provided by including in each marker at least one area having a plurality of small elements on a contrasting background.

Still further, the invention provides a lithographic apparatus arranged to perform the above described methods and computer program to instruct a lithographic apparatus to perform the methods of the invention.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of 365, 248, 193, 157 or 126 nm) and extreme ultra-violet (EUV) radiation (e.g. having a wavelength in the range of 5-20 nm), as well as particle beams, such as ion beams or electron beams.

The term "patterning means" used herein should be broadly interpreted as referring to means that can be used to impart a projection beam with a pattern in its cross-section such as to create a pattern in a target portion of the substrate. It should be noted that the pattern imparted to the projection beam may not exactly correspond to the desired pattern in the target portion of the substrate. Generally, the pattern imparted to the projection beam will correspond to a particular functional layer in a device being created in the target portion, such as an integrated circuit.

Patterning means may be transmissive or reflective. Examples of patterning means include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions; in this manner, the reflected beam is patterned. In each example of patterning means, the support structure may be a frame or table, for example, which may be fixed or movable as required and which may ensure that the patterning means is at a desired position, for example with respect to the projection system. Any use of the terms "reticle" or "mask" herein may be considered synonymous with the more general term "patterning means".

The term "projection system" used herein should be broadly interpreted as encompassing various types of projection system, including refractive optical systems, reflective optical systems, and catadioptric optical systems, as appropriate for example for the exposure radiation being used, or for other factors such as the use of an immersion fluid or the use of a vacuum. Any use of the term "lens" herein may be considered as synonymous with the more general term "projection system".

The illumination system may also encompass various types of optical components, including refractive, reflective, and catadioptric optical components for directing, shaping, or controlling the projection beam of radiation, and such components may also be referred to below, collectively or singularly, as a "lens".

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

The lithographic apparatus may also be of a type wherein the substrate is immersed in a liquid having a relatively high refractive index, e.g. water, so as to fill a space between the final element of the projection system and the substrate. Immersion liquids may also be applied to other spaces in the lithographic apparatus, for example, between the mask and the first element of the projection system. Immersion techniques are well known in the art for increasing the numerical aperture of projection systems.

Embodiments of the invention will now be'described, by way of example only, with reference to the accompanying schematic drawings in which corresponding reference symbols indicate corresponding parts, and in which:
- Figure 1 depicts a lithographic apparatus usable in embodiments of the present invention;
- Figure 2 shows a modified alignment marker usable in embodiments of the present invention;
- Figure 3 is an enlarged view of a part of the line structure of the alignment marker of Figure 2;
- Figures 4A to E are views showing the effect of etching the alignment marker of Figure 2 at different angles;
- Figure 5 is a plan view of a substrate according to an embodiment of the invention; and
- Figure 6 is a graph of apparent position vs. angle used in an embodiment of the invention.

### EMBODIMENTS

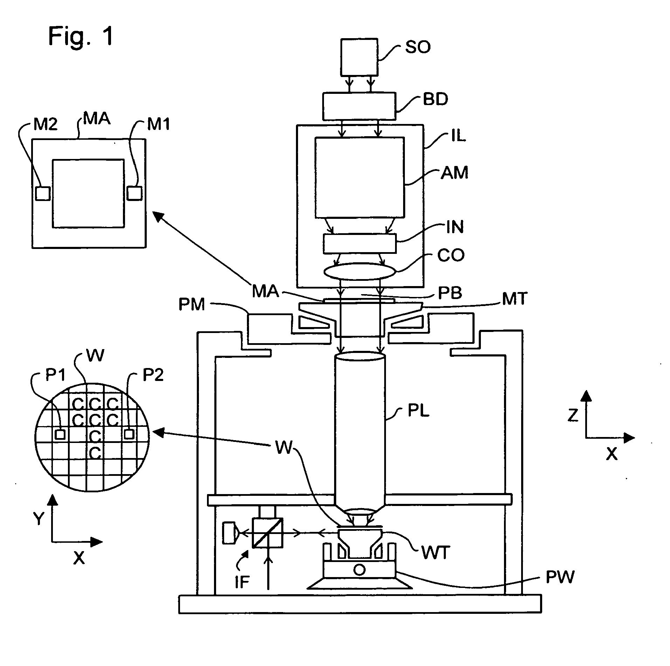

Figure 1 schematically depicts a lithographic apparatus according to a particular embodiment of the invention. The apparatus comprises:
- an illumination system (illuminator) IL for providing a projection beam PB of radiation (e.g. UV radiation or DUV radiation).
- a first support structure (e.g. a mask table) MT for supporting patterning means (e.g. a mask) MA and connected to first positioning means PM for accurately positioning the patterning means with respect to item PL;
- a substrate table (e.g. a wafer table) WT for holding a substrate (e.g. a resist-coated wafer) W and connected to second positioning means PW for accurately positioning the substrate with respect to item PL; and
- a projection system (e.g. a refractive projection lens) PL for imaging a pattern imparted to the projection beam PB by patterning means MA onto a target portion C (e.g. comprising one or more dies) of the substrate W.

As here depicted, the apparatus is of a transmissive type (e.g. employing a transmissive mask). Alternatively, the apparatus may be of a reflective type (e.g. employing a programmable mirror array of a type as referred to above).

The illuminator IL receives a beam of radiation from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising for example suitable directing mirrors and/or a beam expander. In other cases the source may be integral part of the apparatus, for example when the source is a mercury lamp. The source SO and the illuminator IL, together with the beam delivery system BD if required, may be referred to as a radiation system.

The illuminator IL may comprise adjusting means AM for adjusting the angular intensity distribution of the beam. Generally, at least the outer and/or inner radial extent (commonly referred to as σ-outer and σ-inner, respectively) of the intensity distribution in a pupil plane of the illuminator can be adjusted. In addition, the illuminator IL generally comprises various other components, such as an integrator IN and a condenser CO. The illuminator provides a conditioned beam of radiation, referred to as the projection beam PB, having a desired uniformity and intensity distribution in its cross-section.

The projection beam PB is incident on the mask MA, which is held on the mask table MT. Having traversed the mask MA, the projection beam PB passes through the lens PL, which focuses the beam onto a target portion C of the substrate W. With the aid of the second positioning means PW and position sensor IF (e.g. an interferometric device), the substrate table WT can be moved accurately, e.g. so as to position different target portions C in the path of the beam PB. Similarly, the first positioning means PM and another position sensor (which is not explicitly depicted in Figure 1) can be used to accurately position the mask MA with respect to the path of the beam PB, e.g. after mechanical retrieval from a mask library, or during a scan. In general, movement of the object tables MT and WT will be realized with the aid of a long-stroke module (coarse positioning) and a short-stroke module (fme positioning), which form part of the positioning means PM and PW. However, in the case of a stepper (as opposed to a scanner) the mask table MT may be connected to a short stroke actuator only, or may be fixed. Mask MA and substrate W may be aligned using mask alignment marks M1, M2 and substrate alignment marks P1, P2.

The depicted apparatus can be used in the following preferred modes:
1. In step mode, the mask table MT and the substrate table WT are kept essentially stationary, while an entire pattern imparted to the projection beam is projected onto a target portion C in one go (i.e. a single static exposure). The substrate table WT is then shifted in the X and/or Y direction so that a different target portion C can be exposed. In step mode, the maximum size of the exposure field limits the size of the target portion C imaged in a single static exposure.
2. In scan mode, the mask table MT and the substrate table WT are scanned synchronously while a pattern imparted to the projection beam is projected onto a target portion C (i.e. a single dynamic exposure). The velocity and direction of the substrate table WT relative to the mask table MT is determined by the (de-)magnification and image reversal characteristics of the projection system PL. In scan mode, the maximum size of the exposure field limits the width (in the non-scanning direction) of the target portion in a single dynamic exposure, whereas the length of the scanning motion determines the height (in the scanning direction) of the target portion.
3. In another mode, the mask table MT is kept essentially stationary holding a programmable patterning means, and the substrate table WT is moved or scanned while a pattern imparted to the projection beam is projected onto a target portion C. In this mode, generally a pulsed radiation source is employed and the programmable patterning means is updated as required after each movement of the substrate table WT or in between successive radiation pulses during a scan. This mode of operation can be readily applied to maskless lithography that utilizes programmable patterning means, such as a programmable mirror array of a type as referred to above.

Combinations and/or variations on the above described modes of use or entirely different modes of use may also be employed.

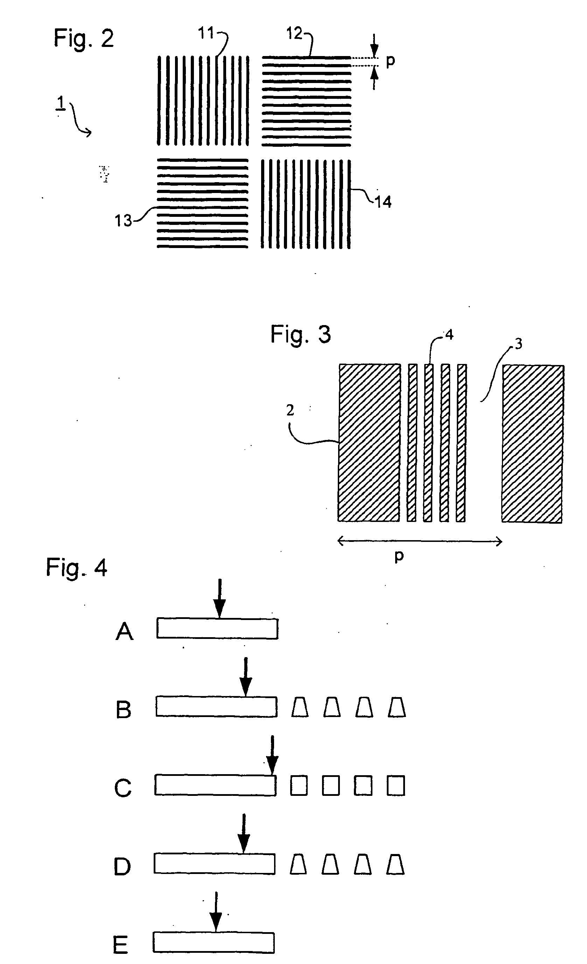

Figure 2 shows an alignment marker 1 which is based on a standard form of marker but modified for use in the invention. As can be seen in Figure 2, the alignment marker 1 comprises four quadrants 11 to 14 each of which comprises a grating structure. Two of the quadrants 11, 14 have their grating lines aligned in a first direction, horizontal in the Figure, and the other two quadrants 12, 13 have their grating lines arranged in the perpendicular direction, vertical in the Figure. The grating lines in quadrants 11 and 14 are modified from the standard form to enable measurement of the orientation of the crystal axis.

As shown in Figure 3, which is an enlarged view of part of the line structure of quadrant 11, the grating period p comprises a structure of three parts: a solid area 2, a clear area 3 and a striped area 4. The striped area has a number of lines, four in the present embodiment but more or fewer may also be used, with a line width and pitch much smaller than the pitch of the grating 14, which may be about 16µm. In general, the critical dimensions of the features of the orientation-sensitive part of the marker are preferably as small as can be printed with the lithographic apparatus used to print the marker. This marker can be made sensitive to its orientation relative to the crystal axis of the substrate by etching it into the substrate using an anisotropic etching step. In such an etching step, the substrate is preferentially etched in a particular direction, e.g. parallel to the {001} crystal axis, as compared to the perpendicular direction. If the marker is aligned to the direction of preferential etching, the orientation-sensitive (striped) parts of the marker will etch more strongly than if the marker is at an angle to that direction so that the center of gravity of the marker will shift. How this effect is achieved is shown in Figures 4A to E.

Figures 4A to E show in cross-section the structures resulting when the marker is exposed in resist at various different angles relative to the crystal axis and then etched into the substrate with an anisotropic etch process. The details of the anisotropic etch procedure will determine the precise angles under which the structures are etched and the exact forms of the structures etched at different angles. As shown in Figure 4A, if the marker is at a large positive angle to the crystal axis, the lines of the stripped area are completely etched away and the marker consists only of the solid parts. When the position of the marker is measured, the result is a positioned centered on the solid areas, as shown by the arrow. If the marker is at a small angle relative to the crystal axis, Figure 4B, the stripped lines will appear in the etched marker but with reduced widths. The measured position, which relates to the center of gravity of the marker, will be shifted over as indicated by the arrow. With the marker correctly aligned, Figure 4C, with the crystal axis, the stripped area will appear fully in the etched structure and the displacement of the measured position will be maximum. The effect is the same for negative angles, as shown in Figures 4D & E. The same effect can be achieved in other types of marker using areas that are similarly striped or have other sub-resolution divisions.

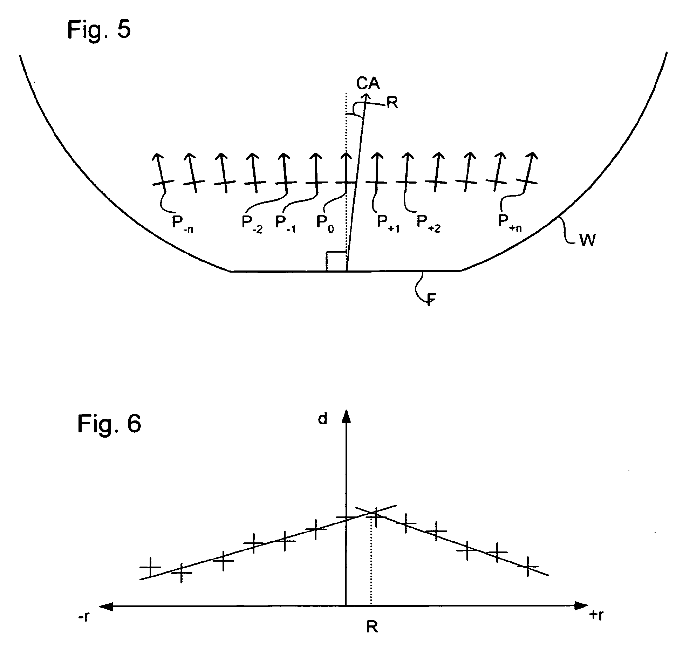

Figure 5 shows a wafer W on which the method of the present invention is used to find the orientation of the crystal axis CA. The wafer W has a flat F which is nominally perpendicular to the crystal axis CA but in practice the crystal axis CA may be at an angle R of up to ±1° away from the normal to the flat. (NB certain angles and the sizes of the markers in Figure 5 are exaggerated for clarity.)

A series of alignment markers P₋ₙ to P₊ₙ, as described above (but represented in Figure 5 by arrows), is exposed into resist on the substrate at differing angles rₙ relative to the normal to the flat F. The angles of the markers P₋ₙ to P₊ₙ should span, and preferably go beyond, the range of possible angles of the crystal axis C and should be sufficient in number to provide a sufficient number of data points for interpolation and to average errors. The markers are preferably exposed under the same conditions (or else relevant variations are factored out later in the method) and preferably conditions optimum for the correct imaging of the striped part of the marker. The markers may be exposed in a single exposure, with a suitable mask containing images of all the markers at the respective angles, or in separate exposures, using a mask with an image of a single marker with the substrate rotated appropriately for each imaging step. The markers are preferably printed close together to minimize any position dependent effects in imaging and may be printed in any spare space on the substrate if it is to be used for production of devices. There is no need for the markers to be positioned with a specific or consistent relationship between their position and their orientation relative to the normal to the flat F but their relative positions must be known to an appropriate degree of accuracy. If the global position markers have already been printed on the substrate, or are printed at the same time, the predetermined positions of the markers for crystal axis determination are preferably known relative to the global position markers.

The resist is then developed in the usual way and the alignment markers P₋ₙ to P₊ₙ are etched into the substrate with an anisotropic etching process. The exact etching process will depend on the material of the substrate, suitable processes are known for common substrate materials. For example, a suitable anisotropic etching process for a silicon substrate is a KOH etch for which the process conditions, especially the temperature, can be optimized to maximize the directional selectivity of the etch.

To determine the orientation of the crystal axis CA, the absolute positions of the etched markers P₋ₙ to P₊ₙ are measured using a standard alignment tool, e.g. the alignment tool built into a lithographic projection apparatus, and their displacements d from their expected positions are determined. The alignment scans may'be carried out with the substrate table appropriately rotated so that the scans are correctly perpendicular to the markers. As discussed above, the closer the orientation of the alignment marker is to the crystal axis CA, the more strongly the striped part will have etched and so the more its center of gravity will have shifted, leading to a greater displacement of measured position from the nominal position at which it was exposed. The marker with the greatest apparent displacement can therefore be used as an indication of the orientation of the crystal axis. However, for greater accuracy, the displacements of all markers can be considered. For example, the displacements d may be fitted to two straight lines, one rising and one falling with increasing angle relative to the normal to the flat, and the orientation of the crystal axis is then determined from the intersection of the two lines, as shown in Figure 6.

Once the orientation of the crystal axis relative to the flat is known, this value may be taken into account in the production of devices on the substrate. In particular a device whose function is dependent on, or improved by, an exact alignment with one or other crystal axis (if the orientation of one crystal axis is known it is of course a matter of simple geometry to determine the orientation of the others) can be correctly positioned on the device. Correct positioning may be achieved by using known crystal axis orientation to appropriately position the global positioning (zero level) markers on the substrate or, if the positions of these are already fixed, the crystal axis orientation can be carried forward as a correction factor applied after alignment to the global positioning markers.

It will be appreciated that the steps of the present invention need not all be carried out at the same time or place. For example, the series of markers may be exposed and etched at the time and place of manufacture of the substrate whereas the measurement of the apparent displacements and the determination of the value of the offset may be carried out when devices are to be exposed on the substrate. This, as with the case when all steps are carried out at the time of production of devices, has the advantage that the existing, highly accurate alignment systems of a lithographic apparatus may be used for the measurements. Also, if the substrate is not removed from a substrate table between measurement of the crystal axis offset and printing of the global positioning markers, then the possibility of error in using the flat as a reference is avoided.

It is however also possible to carry out all steps up to determination of the orientation of the crystal axis remotely from the production of devices, e.g. at the time of manufacture of the substrates. In this case it is particularly convenient to take advantage of the fact that the flat, or notch in the case of flatless wafers, is generally created before the individual substrates are cut from a single crystal. All wafers cut from one crystal will therefore have the same orientation of crystal axis relative to the flat (or notch). Thus, the measurement of the invention can be carried out on one (or perhaps a sample to minimize error) substrate cut from a given crystal and the result then applied to all substrates cut from that crystal. The measurement result, whether derived from individual measurements or batch measurements, may be marked on the substrate or an associated data carrier, in machine or human readable form, or entered into a database for retrieval at the time of use of the substrate.

It will be appreciated that if the markers used in the method of the present invention take up an undesirable amount of space on the substrate, they may be put on the opposite side of the substrate to that used for production of devices, remembering of course that the offset value will need to have its sign changed when applied after inversion of the wafer. It may also be possible in some circumstances to remove the markers after they have been used in the method of the invention.

In some cases the invention can be implemented in the form of a software upgrade to an existing apparatus and hence may be provided in the form of a computer program that includes code that is executed by the supervisory control system of the lithographic apparatus and instructs the lithographic apparatus to perform the steps of the method of the invention.

While specific embodiments of the invention have been described above, it will be appreciated that the invention may be practiced otherwise than as described. The description is not intended to limit the invention.

## Claims

1. A method of preparing a substrate (W) comprising:
providing on a surface of said substrate a plurality of alignment markers (Pₙ) at respective predetermined positions, different ones of said alignment markers (Pₙ) having different orientations relative to a crystal axis of said substrate and the form of said alignment markers (Pₙ) being such that their apparent position is dependent on their orientation relative to said crystal axis,
**characterized in that** the alignment markers (Pₙ) each comprise a structure the structure comprising a solid area (2), a clear area (3) and a striped area (4).

2. A method according to claim 1 wherein the orientations of said alignment markers (Pₙ) differ from each other by amounts in the range of from (5x10⁻⁶)° to 4°.

3. A method according to claim 1 or 2 wherein said plurality of alignment markers (Pₙ) have orientations spanning a range of between 0.5° to 2° either side of a nominal orientation of said crystal axis (CA).

4. A method according to claim 1, 2 or 3 wherein providing said alignment markers (Pₙ) comprises etching said alignment markers (Pₙ) into said substrate (W) using an anisotropic etching process.

5. A method of determining the orientation of the crystal structure of a substrate (W), the substrate having provided thereon a plurality of alignment markers (Pₙ) at respective predetermined positions, different ones of said alignment markers having different orientations relative to a crystal axis (CA) of said substrate and each comprising a structure (p), the structure comprising a solid area (2), a clear area (3) and a striped area (4); the method comprising:
measuring the positions of said plurality of alignment markers (Pₙ);
determining the deviations of the measured positions of said alignment markers from said predetermined positions;
determining the orientation of said crystal axis (CA) relative to said plurality of alignment markers from said deviations.

6. A method according to claim 5 further comprising marking on said substrate (W) and/or other substrates cut from the same crystal, information indicative of the determined orientation.

7. A method according to claim 5 or 6 further comprising making an entry in a database representing said determined orientation.

8. A device manufacturing method comprising the steps of:
- providing a substrate (W);
- providing a projection beam (PB) of radiation using an illumination system (IL);
- using patterning means (MA) to impart the projection beam with a pattern (C) in its cross-section; and
- projecting the patterned beam of radiation onto a target portion of the substrate (W),
**characterized in that** during said projection, the orientation of said substrate relative to the projected pattern is determined at least in part by reference to information indicative of the orientation of a crystal axis (CA) that has been determined by the method of claim 5, 6 or 7.

9. A method according to claim 8 wherein said projection is directed onto a first side of said substrate (W) and said substrate has provided on a second side thereof a plurality of alignment markers (Pₙ) at respective predetermined positions, different ones of said alignment markers having different orientations relative to a crystal axis (CA) of said substrate

10. A method according to claim 8 wherein said projection is directed onto a first substrate (W) and said information indicative of the orientation of a crystal axis (CA) has been derived from measurements of a second substrate, said first and second substrates having been cut from the same single crystal.

11. A method according to any one of the preceding claims wherein said alignment markers (Pₙ) are selected from the group comprising: gratings, groups of gratings, chevrons, boxes.

12. A method according to any one of the preceding claims wherein each said alignment marker (Pₙ) comprises at least one area having a plurality of small elements on a contrasting background.

13. A lithographic apparatus comprising:
- an illumination system (IL) for providing a projection beam (PB) of radiation;
- a support structure (MT) for supporting patterning means (MA), the patterning means serving to impart the projection beam with a pattern (C) in its cross-section;
- a substrate table (WT) for holding a substrate (W);
- a projection system (PL) for projecting the patterned beam onto a target portion of the substrate; and
- an alignment system (PW) for measuring the positions of alignment markers on said substrate;
**characterized by** control means for controlling said apparatus to perform the method of any one of claims 5 to 10.

14. A computer program comprising program code means that, when executed on a lithographic apparatus, instruct the apparatus to perform the method of any one of claims 5 to 10.

15. A substrate (W) having thereon a plurality of alignment markers (Pₙ) at respective predetermined positions, different ones of said alignment markers having different orientations relative to a crystal axis (CA) of said substrate and the form of said alignment markers being such that their apparent position is dependent on their orientation relative to said crystal axis, **characterized in that** the alignment markers (Pₙ) each comprise a structure (p), the structure comprising a solid area (2), a clear area (3) and a striped area (4).

## Patentansprüche

1. Verfahren zum Vorbereiten eines Substrats (W), umfassend:
Bereitstellen einer Vielzahl von Justiermarkierungen (Pₙ) an entsprechend vorbestimmten Positionen auf einer Oberfläche des Substrats, wobei unterschiedliche Justiermarkierungen (Pₙ) unterschiedliche Ausrichtungen relativ zu einer Kristallachse des Substrats haben und die Form der Justiermarkierungen (Pₙ) derart ist, dass ihre sichtbare Position von ihrer Ausrichtung relativ zu der Kristallachse abhängt,
**dadurch gekennzeichnet, dass** die Justiermarkierungen (Pₙ) jeweils eine Struktur aufweisen, die einen festen Bereich (2), einen klaren Bereich (3) und einen gestreiften Bereich (4) aufweist.

2. Verfahren nach Anspruch 1, bei dem sich die Ausrichtungen der Justiermarkierungen (Pₙ) in einem Bereich von (5x10⁻⁶)° bis 4° voneinander unterscheiden.

3. Verfahren nach Anspruch 1 oder 2, bei dem die Vielzahl von Justiermarkierungen (Pₙ) Ausrichtungen aufweisen, die an beiden Seiten einer nominalen Ausrichtung der Kristallachse (CA) einen Bereich von 0,5° bis 2° überspannen.

4. Verfahren nach Anspruch 1, 2 oder 3, bei dem das Bereitstellen der Justiermarkierungen (Pₙ) das Ätzen der Justiermarkierungen (Pₙ) in das Substrat (W) unter Einsatz eines anisotropischen Ätzprozesses umfasst.

5. Verfahren zum Bestimmen der Ausrichtung der Kristallstruktur eines Substrats (W), wobei das Substrat an entsprechend vorbestimmten Positionen eine Vielzahl von darauf vorgesehenen Justiermarkierungen (Pₙ) aufweist, und wobei unterschiedliche Justiermarkierungen unterschiedliche Ausrichtungen relativ zu einer Kristallachse (CA) des Substrats haben und jeweils eine Struktur (p) aufweisen, die einen festen Bereich (2), einen klaren Bereich (3) und einen gestreiften Bereich (4) aufweist, umfassend:
Messen der Positionen der Vielzahl von Justiermarkierungen (Pₙ);
Bestimmen der Abweichungen der gemessenen Positionen der Justiermarkierungen von den vorbestimmten Positionen;
Bestimmen der Ausrichtung der Kristallachse (CA) relativ zu der Vielzahl von Justiermarkierungen anhand der Abweichungen.

6. Verfahren nach Anspruch 5, des weiteren umfassend das Markieren des Substrats (W) und/oder anderer Substrate, die aus dem gleichen Kristall geschnitten sind, mit Informationen, die die vorbestimmte Ausrichtung anzeigen.

7. Verfahren nach Anspruch 5 oder 6, des Weiteren umfassend das Vornehmen einer Eintragung in eine Datenbank, die die bestimmte Ausrichtung darstellt.

8. Verfahren zum Herstellen eines Bauelements, umfassend die Schritte:
- Bereitstellen eines Substrats (W);
- Bereitstellen eines Projektionsstrahls (PB) aus Strahlung unter Verwendung eines Illuminationssystems (IL);
- Verwenden einer Musteraufbringungseinrichtung (MA), um den Querschnitt des Projektionsstrahls mit einem Muster (C) zu versehen; und
- Projizieren des gemusterten Strahls aus Strahlung auf einen Zielabschnitt des Substrats (W),
**dadurch gekennzeichnet, dass** während der Projektion die Ausrichtung des Substrats relativ zu dem projizierten Muster zumindest teilweise **dadurch** bestimmt wird, dass Bezug genommen wird auf Informationen, die die Ausrichtung einer Kristallachse (CA) anzeigen, welche durch das Verfahren der Ansprüche 5, 6 oder 7 bestimmt worden ist.

9. Verfahren nach Anspruch 8, bei dem die Projektion auf eine erste Seite des Substrats (W) gerichtet wird und das Substrat an seiner zweiten Seite eine Vielzahl von Justiermarkierungen (Pₙ) an entsprechend vorbestimmten Positionen aufweist, wobei unterschiedliche Justiermarkierungen unterschiedliche Ausrichtungen relativ zu einer Kristallachse (CA) des Substrats haben.

10. Verfahren nach Anspruch 8, bei dem die Projektion auf ein erstes Substrat (W) gerichtet wird und die Informationen, welche die Ausrichtung einer Kristallachse (CA) anzeigen, anhand von Messungen an einem zweiten Substrat abgeleitet worden sind, und bei dem das erste und das zweite Substrat aus dem gleichen Einkristall geschnitten worden sind.

11. Verfahren nach einem der vorhergehenden Ansprüche, bei dem die Justiermarkierungen (Pₙ) aus der Gruppe bestehend aus Gittern, Gittergruppen, V-förmigen Mustern und kastenförmigen Mustern ausgewählt sind.

12. Verfahren nach einem der vorhergehenden Ansprüche, bei dem jede Justiermarkierung (Pₙ) zumindest einen Bereich aufweist, der eine Vielzahl kleiner Elemente auf einem abgesetzten Hintergrund besitzt.

13. Lithographische Vorrichtung, umfassend:
- ein Illuminationssystem (IL) zum Bereitstellen eines Projektionsstrahls (PB) aus Strahlung;
- einen Halteraufbau (MT) zum Halten einer Musteraufbringungseinrichtung (MA), wobei die Musteraufbringungseinrichtung dazu dient, den Querschnitt des Projektionsstrahls mit einem Muster (C) zu versehen;
- einen Substrattisch (WT) zum Halten eines Substrats (W);
- ein Projektionssystem (PL) zum Projizieren des gemusterten Strahls auf einen Zielabschnitt des Substrats; und
- ein Justiersystem (PW) zum Messen der Positionen der Justiermarkierungen auf dem Substrat;
**gekennzeichnet durch** eine Steuerungseinrichtung zum Steuern der Vorrichtung derart, dass sie das Verfahren nach einem der Ansprüche 5 bis 10 ausführt.

14. Computerprogramm, das eine Programmcodeeinrichtung aufweist, die, wenn sie an einer lithographischen Vorrichtung ausgeführt wird, die Vorrichtung derart anweist, dass sie das Verfahren nach einem der Ansprüche 5 bis 10 ausführt.

15. Substrat (W), das darauf an entsprechend vorbestimmten Positionen eine Vielzahl von Justiermarkierungen (Pₙ) aufweist, wobei unterschiedliche Justiermarkierungen unterschiedliche Ausrichtungen relativ zu einer Kristallachse (CA) des Substrats haben und die Form der Justiermarkierungen derart ist, dass ihre sichtbare Position von ihrer Ausrichtung relativ zu der Kristallachse abhängt,
**dadurch gekennzeichnet, dass** die Justiermarkierungen (Pₙ) jeweils eine Struktur (p) aufweisen, die einen festen Bereich (2), einen klaren Bereich (3) und einen gestreiften Bereich (4) aufweist.

## Revendications

1. Procédé de préparation d'un substrat (W) comprenant :
la fourniture sur une surface dudit substrat d'une pluralité de marqueurs d'alignement (Pₙ) dans des positions prédéterminées respectives, différents marqueurs parmi lesdits marqueurs d'alignement (Pₙ) ayant différentes orientations par rapport à un axe de cristal dudit substrat et la forme desdits marqueurs d'alignement (Pₙ) étant telle que leur position apparente est dépendante de leur orientation par rapport audit axe de cristal,
**caractérisé en ce que** les marqueurs d'alignement (Pₙ) comprennent chacun une structure, la structure comprenant une zone pleine (2), une zone vide (3) et une zone rayée (4).

2. Procédé selon la revendication 1 dans lequel les orientations desdits marqueurs d'alignement (Pₙ) diffèrent les unes des autres par des quantités dans la plage de (5 × 10⁻⁶)° à 4°.

3. Procédé selon la revendication 1 ou 2 dans lequel ladite pluralité de marqueurs d'alignement (Pₙ) a des orientations couvrant une plage entre 0,5° et 2° de chaque côté d'une orientation nominale dudit axe de cristal (CA).

4. Procédé selon la revendication 1, 2 ou 3 dans lequel la fourniture desdits marqueurs d'alignement (Pₙ) comprend la gravure desdits marqueurs d'alignement (Pₙ) dans ledit substrat (W) en utilisant un processus de gravure anisotrope.

5. Procédé pour déterminer l'orientation de la structure de cristal d'un substrat (W), le substrat ayant, agencé sur lui, une pluralité de marqueurs d'alignement (Pₙ) dans des positions prédéterminées respectives, différents marqueurs parmi lesdits marqueurs d'alignement ayant différentes orientations par rapport à un axe de cristal (CA) dudit substrat et comprenant chacun une structure (p), la structure comprenant une zone pleine (2), une zone vide (3) et une zone rayée (4) ; le procédé comprenant :
la mesure des positions de ladite pluralité de marqueurs d'alignement (Pₙ) ;
la détermination des écarts des positions mesurées desdits marqueurs d'alignement par rapport auxdites positions prédéterminées ;
la détermination de l'orientation dudit axe de cristal (CA) par rapport à ladite pluralité de marqueurs d'alignement, à partir desdits écarts.

6. Procédé selon la revendication 5 comprenant également le marquage sur ledit substrat (W) et/ou d'autres substrats découpés à partir du même cristal, d'informations indicatives de l'orientation déterminée.

7. Procédé selon la revendication 5 ou 6 comprenant en outre la saisie d'une entrée dans une base de données représentant ladite orientation déterminée.

8. Procédé de fabrication de dispositif comprenant les étapes de :
fournir un substrat (W) ;
fournir un faisceau de projection (PB) de rayonnement en utilisant un système d'éclairage (IL) ;
utiliser des moyens de mise en forme (MA) pour doter le faisceau de projection d'un motif (C) dans sa section transversale ; et
projeter le faisceau de rayonnement mis en forme sur une partie cible du substrat (W),
**caractérisé en ce que** pendant ladite projection, l'orientation dudit substrat par rapport au motif projeté est déterminée au moins en partie en référence à des informations indicatives de l'orientation d'un axe de cristal (CA) qui a été déterminée par le procédé de la revendication 5, 6 ou 7.

9. Procédé selon la revendication 8 dans lequel ladite projection est dirigée sur un premier côté dudit substrat (W) et ledit substrat comprend, sur un second côté de celui-ci, une pluralité de marqueurs d'alignement (Pₙ) dans des positions prédéterminées respectives, différents marqueurs parmi lesdits marqueurs d'alignement ayant différentes orientations par rapport à un axe de cristal (CA) dudit substrat.

10. Procédé selon la revendication 8 dans lequel ladite projection est dirigée sur un premiers substrat (W) et lesdites informations indicatives de l'orientation d'un axe de cristal (CA) ont été obtenues à partir de mesures d'un second substrat, lesdits premier et second substrats ayant été découpés à partir du même monocristal.

11. Procédé selon l'une quelconque des revendications précédentes dans lequel lesdits marqueurs d'alignement (Pₙ) sont sélectionnés parmi le groupe comprenant : des réseaux, des groupes de réseaux, des chevrons, des cases.

12. Procédé selon l'une quelconque des revendications précédentes dans lequel chaque dit marqueur d'alignement (Pₙ) comprend au moins une zone ayant une pluralité de petits éléments sur un fond contrasté.

13. Appareil lithographique comprenant :
- un système d'éclairage (IL) pour délivrer un faisceau de projection (PB) de rayonnement ;
- une structure de support (MT) pour supporter des moyens de mise en forme (MA), les moyens de mise en forme servant à doter le faisceau de projection d'un motif (C) dans sa section transversale ;
- une table de substrat (WT) pour maintenir un substrat (W) ;
- un système de projection (PL) pour projeter le faisceau mis en forme sur une partie cible du substrat ; et
- un système d'alignement (PW) pour mesurer les positions de marqueurs d'alignement sur ledit substrat ;
**caractérisé par** des moyens de commande pour commander ledit appareil pour exécuter le procédé selon l'une quelconque des revendications 5 à 10.

14. Programme informatique comprenant des moyens formant code de programme qui, lorsque exécutés sur un appareil lithographique, ordonnent à l'appareil d'exécuter le procédé selon l'une quelconque des revendications 5 à 10.

15. Substrat (W) ayant sur lui une pluralité de marqueurs d'alignement (Pₙ) dans des positions prédéterminées respectives, différents marqueurs parmi lesdits marqueurs d'alignement ayant différentes orientations par rapport à un axe de cristal (CA) dudit substrat et la forme desdits marqueurs d'alignement étant telle que leur position apparente est dépendante de leur orientation par rapport audit axe de cristal,
**caractérisé en ce que** les marqueurs d'alignement (Pₙ) comprennent chacun une structure (p), la structure comprenant une zone pleine (2), une zone vide (3) et une zone rayée (4).
